# EUROPEAN PATENT SPECIFICATION

(11) **EP 2 557 932 B1**
(45) Date of publication and mention of the grant of the patent: **21.03.2018**
(21) Application number: 11716097.8
(22) Date of filing: 12.04.2011
(51) Int. Cl.: C23C 14/34, C23C 14/08, A01N 59/16, C03C 17/34, C03C 17/245

(54) **METHOD OF MAKING COATED ARTICLE HAVING ANTI-BACTERIAL AND/OR ANTI-MICROBIAL COATING**
VERFAHREN ZUR HERSTELLUNG EINES BESCHICHTETEN ARTIKELS MIT ANTIBAKTERIELLER UND/ODER ANTIMIKROBIELLER BESCHICHTUNG
PROCÉDÉ DE FABRICATION D'ARTICLE RECOUVERT AYANT UN REVÊTEMENT ANTIBACTÉRIEN ET/OU ANTIMICROBIEN

(30) Priority: 16.04.2010 US 662443
(43) Date of publication of application: 20.02.2013
(73) Proprietor: Guardian Glass, LLC, Auburn Hills MI 48326 (US)
(72) Inventor: WANG, Jiangping, Novi, MI 48377 (US); PETRMICHL, Rudolph H., Ann Arbor, MI 48108 (US); LEMMER, Jean-marc, Ann Arbor, MI 48108 (US)
(74) Representative: Hess, Peter K. G.
(86) International application number: PCT/US2011/000664
(87) International publication number: WO 2011/129882

(56) References cited:
- WO-A1-92/01081
- WO-A1-2008/010883
- WO-A1-2008/152135
- WO-A1-2010/052842
- WO-A2-2007/087269
- WO-A2-2009/007448
- JP-A- S63 465
- US-A1- 2004 151 942
- US-A1- 2007 254 163
- US-A1- 2010 015 193
- CHIA-HAN YANG ET AL: "Failure analysis of nanocrystals embedded high-k dielectrics for nonvolatile memories", RELIABILITY PHYSICS SYMPOSIUM, 2008. IRPS 2008. IEEE INTERNATIONAL, IEEE, PISCATAWAY, NJ, USA, 27 April 2008 (2008-04-27), pages 46-49, XP031283144, ISBN: 978-1-4244-2049-0
- CHEN-HAN LIN ET AL: "Nonvolatile Memories with Dual-Layer Nanocrystalline ZnO Embedded Zr-Doped HfO[sub 2] High-k Dielectric", ELECTROCHEMICAL AND SOLID-STATE LETTERS, vol. 13, no. 3, 1 January 2010 (2010-01-01), pages H83-H86, XP55009350, ISSN: 1099-0062, DOI: 10.1149/1.3276055
- SATYESH KUMAR YADAV ET AL: "Study of Electrical and Optical Properties of Zr-Doped ZnO Thin Films Prepared by DC Reactive Magnetron Sputtering", NANOMATERIALS AND DEVICES : PROCESSING AND APPLICATIONS ; [SELECTED, PEER REVIEWED PAPERS PRESENTED AT THE INTERNATIONAL CONFERENCE ON NANOMATERIALS AND DEVICES: PROCESSING AND APPLICATIONS (NADPA 2008) HELD AT THE INDIAN INSTITUTE OF TECHNOLOGY ROOR, 1 April 2009 (2009-04-01), pages 161-166, XP009154717, ISBN: 978-0-87849-328-9
- ZHANG H ET AL: "Influence of annealing temperature on the properties of ZnO:Zr films deposited by direct current magnetron sputtering", VACUUM, PERGAMON PRESS, GB, vol. 84, no. 6, 4 February 2010 (2010-02-04), pages 833-836, XP026872804, ISSN: 0042-207X [retrieved on 2009-11-11]
- LÜ MAO-SHUI ET AL: "Effect of RF power on the properties of transparent conducting zirconium-doped zinc oxide films prepared by RF magnetron sputtering", CHINESE PHYSICS, INSTITUTE OF PHYSICS PUBLISHING, BRISTOL, GB, vol. 16, no. 2, 1 February 2007 (2007-02-01), pages 548-552, XP020121057, ISSN: 1009-1963, DOI: 10.1088/1009-1963/16/2/044

## Description

This invention relates to a method of making a coated article having an anti-fungal/anti-bacterial coating supported by a substrate. Coated articles according to different embodiments of this invention may be used for windows, table tops, picture frame covers, furniture glass, and the like.

### BACKGROUND OF THE INVENTION

Vehicle windows (e.g., windshields, backlites, sunroofs, and sidelites) are known in the art. For purposes of example, vehicle windshields typically include a pair of bent glass substrates laminated together via a polymer interlayer such as polyvinyl butyral (PVB).

Insulating glass (IG) windows are also known in the art. Conventional IG window units include at least first and second glass substrates (one of which may have a solar control coating on an interior surface thereof) that are coupled to one another via at least one seal(s) or spacer(s). The resulting space or gap between the glass substrates may or may not be filled with gas and/or evacuated to a low pressure in different instances. Many IG units are tempered. Thermal tempering of the glass substrates for such IG units typically requires heating the glass substrates to temperature(s) of at least about 580 degrees C for a sufficient period of time to enable thermal tempering. Monolithic architectural windows for use in homes or building are also known in the art. Fixture windows in homes such as shower stall windows may be made of glass sheets. Again, monolithic windows are often thermally tempered for safety purposes.

Other types of coated articles also are sometimes subjected to heat treatment (HT) (e.g., tempering, heat bending, and/or heat strengthening) in certain applications. For example and without limitation, glass table tops, picture frame covers, and the like may be subject to HT in certain instances.

Germs are becoming of increasing concern across the world, especially in view of the large amount of international travel taking place in today's society. There exists a need in the art for coated articles for use in windows, table tops, and/or the like that are capable of killing germs, viruses and/or bacteria, thereby reducing the likelihood of persons becoming sick. It would be advantageous if such characteristics of a coated article could be combined with scratch resistant features in certain example embodiments.

In certain example embodiments there exists a need in the art for a coated article (e.g., for use in a window, shower door, and/or table-top glass) having anti-fungal and/or anti-bacterial properties. In certain example embodiments it may also be desirable for the coated article to have scratch resistance properties. In certain example non-limiting instances, it would be advantageous to provide a coated article that is both scratch resistant and can function to kill certain bacteria and/or fungus which come into contact with the coated article thereby reducing the chances of persons becoming sick.

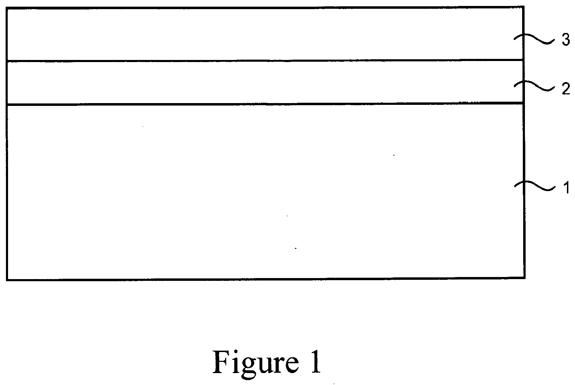

Satyesh Kumar Yadav et al. in Study of Electrical and Optical Properties of Zr-Doped ZnO Thin Films Prepared by DC Reactive Magnetron Sputtering, Nanomaterials and devices: processing and applications; [selected, peer reviewed papers presented at the International Conference on Nanomaterials and Devices: Processing and Applications (NADPA 2008) held at the Indian Institute of Technology Roorkee, India between December 11 - 2009-04-01, discloses a method for making a coated article, the method comprising: providing a first sputtering target comprising Zr; providing a second sputtering target comprising Zn; and co-sputtering from at least the first and second sputtering targets onto a glass substrate to form a layer comprising ZnₓZr_{y}Oz, wherein a different sputtering power (e.g. 150 watt for Zn and 10 watts for Zr respectively) is applied for each of the first and second targets in order to control the composition of the layer and wherein the sputtering targets are offset from each other by an angle that appears to be under 60 degrees from figure 1.

### BRIEF SUMMARY OF EXAMPLES OF INVENTION

Certain example embodiments relate to a method of making a coated article having anti-fungal/anti-bacterial properties, and the resulting product. In certain example non-limiting embodiments, there is provided a method of making a coated article (e.g., window such as for a vehicle or building, shower door window, bus window, subway car window, table top, picture frame cover, or the like) that may be capable of being heat treated so that after being heat treated (HT) the coated article is scratch resistant to an extent more than uncoated glass, as well as more resistant to bacterial and fungal growth than uncoated glass. The coated article may or may not be heat treated in different embodiments.

In certain example embodiments, ZrO₂ and ZnO are co-sputtered on a glass substrate to form a layer comprising zinc zirconium oxide (e.g., ZnₓZr_{y}O_{z}). The glass substrate may or may not be provided with a barrier layer provided between the glass substrate and the layer comprising zinc zirconium oxide. For example and without limitation, the thin barrier layer may comprise silicon nitride, silicon oxide, and/or silicon oxynitride. The co-sputtered zinc zirconium oxide based layer may be provided directly on the glass substrate, or on the glass substrate over other layer(s) such as the barrier layer. While the substrate may be of glass in certain example embodiments of this invention, other materials such as quartz may instead be used for substrates in alternative embodiments. The coated articles described herein may or may not be thermally tempered and/or patterned in certain example embodiments of this invention. Additionally, it will be appreciated that the word "on" as used herein (e.g., a layer "on" something) covers both directly on and indirectly on; e.g., a layer being directly on or indirectly on something with other layer(s) possibly being located therebetween.

In certain reference example embodiments, there is provided method of making a coated article, the method comprising: providing a first sputtering target comprising Zr; providing a second sputtering target comprising Zn; and co-sputtering at least the first and second sputtering targets to form a layer comprising a nitride of Zr doped with Zn on a glass substrate, wherein the layer comprises from about 0.25% to 20% (atomic) Zn. The layer of or including the nitride of Zr doped with Zn may then be heat treated (e.g,. thermally tempered), which causes the layer to transform into a layer comprising or based on zinc zirconium oxide (e.g., ZnₓZr_{y}O_{z}).

In certain example embodiments, the zirconium oxide in the layer comprising zinc zirconium oxide is substantially crystalline, and amorphous zinc oxide is "hidden" in a zirconium oxide (e.g., ZrO₂) matrix, and, for example, can release gradually to the surface such that the coating has lasting anti-microbial properties. The zirconium oxide (e.g., ZrO₂) matrix may be cubic or substantially cubic, with its structure such that it permits zinc particles to migrate or diffuse therethrough to the exterior surface of the coating over long periods of time. When the zinc particles reach the exterior surface of the coated article in a substantially continuous manner over time, they function to kill at least some bacteria and/or fungi that may come into contact with the zinc, or proximate the zinc, on the surface of the coated article.

In certain example embodiments, the zinc is protected from the environment by a porous layer(s) provided over the layer comprising zinc zirconium oxide (e.g., ZnₓZr_{y}O_{z}). In different example embodiments, the zinc zirconium oxide (e.g., ZnₓZr_{y}O_{z}) inclusive layer may comprise, consist essentially of, or consist of Zn, Zr and O.

In order to achieve the structure according to the claims 1 and 2, the zinc or zinc oxide can be "hidden" in a skeleton or matrix of zirconium oxide. In order to "hide" the zinc or zinc oxide in this manner, the coating needs to be co-sputtered in a controlled way as follows.

According to claim 2, the zinc is sputtered from an angled target. More specifically, a Zr inclusive target is substantially perpendicular to the substrate, and a Zn inclusive target is offset from normal by an angle theta (θ). This position assists forming a layer with zinc or zinc oxide "hidden" in a zirconium oxide based matrix, and helps maintain the stability of the crystalline formation in the coating after optional heat-treatment. As used herein, "Zr target" includes a target comprising zirconium and/or zirconium oxide, and "Zn target" includes a target comprising zinc and/or zinc oxide. In certain example embodiments, a Zr target may comprise or consist essentially of Zr, and a Zn target may comprise or consist essentially of Zn. There may be small amounts of other elements included in each target.

According to claim 1, the coating is deposited via power controlled co-sputtering. In this embodiment, the Zr and Zn targets can be substantially parallel or angled from each other, but are sputtered using different amounts of power to control the composition and crystallinity of the coating in a desirable manner.

In a reference example embodiment, one target may comprise zirconium and zinc (and possibly oxides of one or both) in a ratio which operates to help control the composition and crystallinity of the coating. For example, the target may contain a patched or other pattern of zirconium and zinc to ensure that each respective element is deposited in the desired amount, and is in substantially crystalline form (or in a formation that is conducive to becoming crystalline upon heat treatment). The target may comprise any pattern that would create the appropriate ratio and structure when sputtered.

In certain example embodiments, co-sputtered zirconium and zinc oxides result in a zinc zirconium oxide-inclusive layer that exhibits excellent scratch resistance, combined with anti-bacterial and/or anti-microbial properties. It can pass 9.1 kg (=20 lbs) when tested with borosilicate sphere, so that the product is more scratch resistant than is a similar product absent the coating.

### BRIEF DESCRIPTION OF THE DRAWINGS

Figure 1 is a cross-sectional view of an anti-microbial coating according to an example embodiment of this invention.

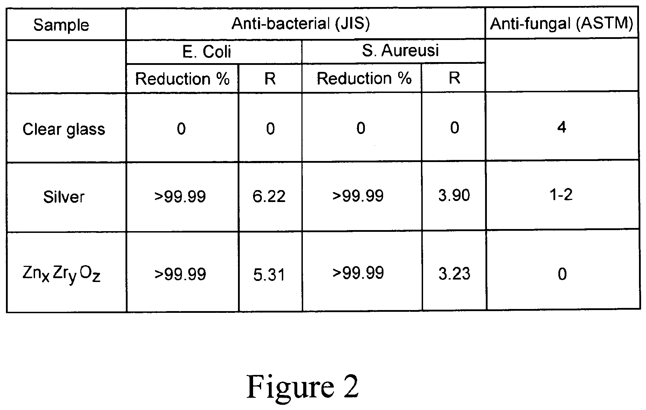

Figure 2 is a table comparing anti-microbial properties of co-sputtered zinc zirconium oxide to those of silver, a traditional anti-microbial coating material, and uncoated glass, according to an example embodiment of this invention.

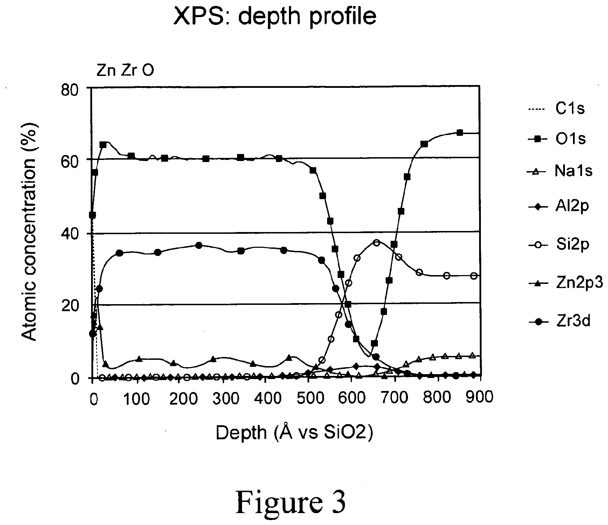

Figure 3 is an XPS depth profile graph of an example composition of a zinc zirconium oxide-inclusive layer according to an example embodiment of this invention.

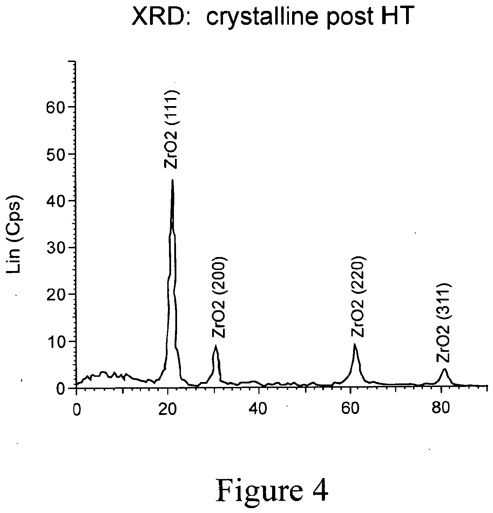

Figure 4 is an XRD of the crystallinity of an example zinc zirconium oxide-based layer after heat treatment/thermal tempering according to an example embodiment of this invention.
Figure 5 shows an angled Zn target according to an example embodiment of this invention.

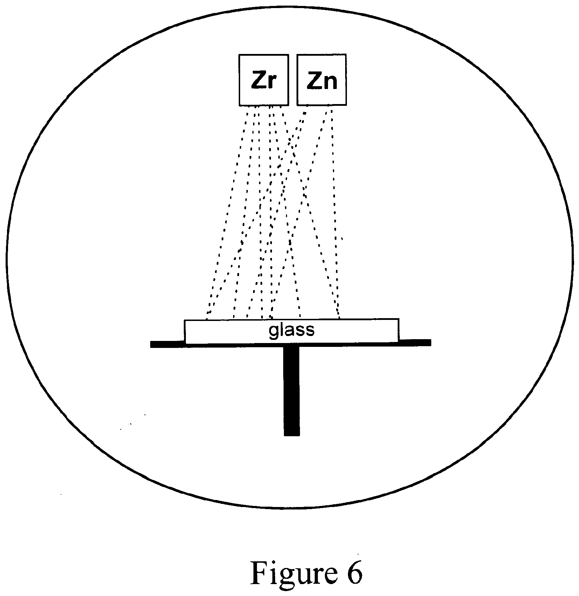

Figure 6 shows power-controlled co-sputtering from both Zn and Zr targets according to another example embodiment of this invention.

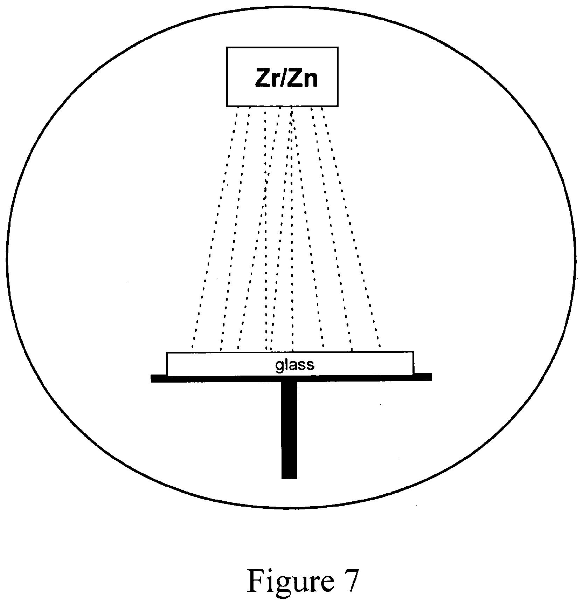

Figure 7 shows sputtering zinc and zirconium from a single, patched target, according to a reference example embodiment.
Figures 8a, 8b, and 8c show a reference example of sequential co-sputtering.

### DETAILED DESCRIPTION OF EXAMPLE EMBODIMENTS

According to the invention, ZrO₂ and ZnO are co-sputtered on a glass substrate 1 to form a layer comprising zinc zirconium oxide 3 which can be the outermost layer of a coated article. The glass substrate may or may not be provided with a barrier layer 2 thereon, with the barrier layer being optionally located between the glass substrate 1 and the layer anti-bacterial and/or anti-microbial layer comprising zinc zirconium oxide 3. For example and without limitation, this thin barrier layer 2 may comprise silicon nitride, silicon oxide, and/or silicon oxynitride in example embodiments. The co-sputtered zinc zirconium oxide-based layer 3 may be provided directly on the glass substrate 1, or on the glass substrate 1 over other layer(s) such as the barrier layer 2. While the substrate 1 may be of glass in certain example embodiments of this invention, other materials such as quartz, plastics or the like may instead be used for substrates in alternative embodiments. The coated article described herein may or may not be thermally tempered and/or patterned in certain example embodiments of this invention.

Silver is a known anti-bacterial agent. However, its anti-fungal properties are lacking. Compared to silver, ZrO₂/ZnO (e.g., forming a ZnₓZr_{y}O_{z}-based layer) according to certain example embodiments of this invention can possess comparable anti-bacterial properties and good anti-fungal properties. Thus, improved anti-fungal properties may be provided in certain example embodiments of this invention.

In reference example embodiments, the layer 3 may originally be deposited as of or including Zn-ZrN, which is zirconium oxide doped with Zn. For example, the zirconium nitride can be doped with from about 0.25% Zn, more preferably from about 0.25% to 15% Zn, more preferably from about 1-15% Zn, more preferably from about 1-10% or 1-5% Zn. Then, when the glass substrate 1 supporting the Zn-ZrN coating is thermally tempered (e.g., heat treated at temperatures of at least about 580 degrees C, or more preferably at least about 600 degrees C), the Zn-ZrN would transform into Zn-ZrO₂ or possibly another form of zirconium oxide doped with the same amounts of Zn discussed above. This would also result in formation of a ZnₓZr_{y}O_{z}-based layer 3. Alternatively the layer 3 may originally be deposed as ZnₓZr_{y}O_{z} or Zn-ZrO₂ according to the invention.

There are two major industrial standards for testing anti-microbial properties of an article. The tests are the JIS test (which tests anti-bacterial properties), and the ASTM test (which tests anti-fungal properties). The JIS test uses a value referred to as "R" to evaluate the anti-bacterial properties of the material being tested. The R value of the surface or article being tested is the log of the ratio of microbe concentration(s) on coated and uncoated products. For example (and without limitation), if R=2, this means that the microbe concentration at the end of the test is 100x less on the coated product than on the uncoated product. R=2 and higher is defined as biocidal. In an ASTM test, the fungal growth is rated from 0-4. 0 is defined as substantially no fungal growth, 1 is defined as traces of growth (less than 10%), 2 is defined as light growth (10-30%), 3 is defined as medium growth (30-60%), and 4 is defined as heavy growth (60% to complete coverage).

An anti-microbial and/or anti-bacterial layer comprising zinc zirconium oxide 3 according to certain example embodiments is surprisingly advantageous, in that it has been found that the layer can kill at least about 80%, more preferably at least about 90%, and most preferably at least about 99.99% E.Coli (R=5.31), and at least about 80%, more preferably at least about 90%, and most preferably at least about 99.94% S. Aureusi (R=3.23) in a JIS test. Moreover, in an anti-fungal (ASTM) test, it shows substantially no growth. The rating of a ZnₓZr_{y}O_{z} based layer 3 made according to certain example embodiments is substantially 0. This surprising and advantageous result indicates that the zinc zirconium oxide-inclusive layer 3 allows substantially no fungal growth, as opposed to materials such as silver, which earn between 1 and 2 on the ASTM scale (up to 30% growth). Table 1 compares the anti-fungal and anti-microbial properties of ZnₓZr_{y}O_{z} based layer 3 to those of silver and glass.

**Table 1**

| **Sample** | **Anti-bacterial (JIS)** | | | | **Anti-fungal (ASTM)** I |
|---|---|---|---|---|---|
| | *E. Coli* | | *S. Aureusi* | | |
| | Reduction % | R | Reduction % | R | |
| Clear glass | 0 | | 0 | 0 | 4 |
| Sliver | >99.99 | | >99.99 | | 1-2 |
| ZrO2/ZnO | >99.99 | | 99.94 | | |

In certain example embodiments, the zinc in the ZnₓZr_{y}O_{z} based layer 3 is protected from the environment by a porous layer(s) provided over the zinc zirconium oxide-based layer. Also in certain example embodiments, a thin barrier layer 2 such as silicon nitride, silicon oxide, and/or silicon oxynitride may be provided underneath the zinc zirconium oxide-based layer 3 to prevent alkali migration from the glass substrate 1 into the coating during optional heat treatment.

According to the invention, zirconium oxide in the layer 3 is crystalline, and amorphous zinc oxide is "hidden" in a zirconium oxide (e.g., ZrO₂) matrix in layer 3, and, for example, can release gradually to the exterior surface of layer 3 such that the coating has lasting anti-microbial properties. The zirconium oxide (e.g., ZrO₂) matrix may be cubic or substantially cubic, with its structure such that it permits zinc particles to migrate or diffuse therethrough to the exterior surface of the layer 3 over periods of time. When the zinc particles reach the surface of the coated article in a substantially continuous manner over time, they function to kill at least some bacteria and/or fungi that may come into contact with the zinc, or proximate the zinc, on the surface of the coated article.

In order to "hide" the zinc oxide in this manner, the zinc zirconium oxide-based layer 3 is co-sputtered in a controlled way according to claim 1 or 2. As used herein, "co-sputtered" may refer to substantially simultaneous sputtering from at least two targets, or sequential sputtering from at least two targets.

The sputtering target(s) discussed below in the example embodiments can be planar target(s), rotating cylindrical magnetron target(s), or a combination thereof. Metal or ceramic targets may be used.

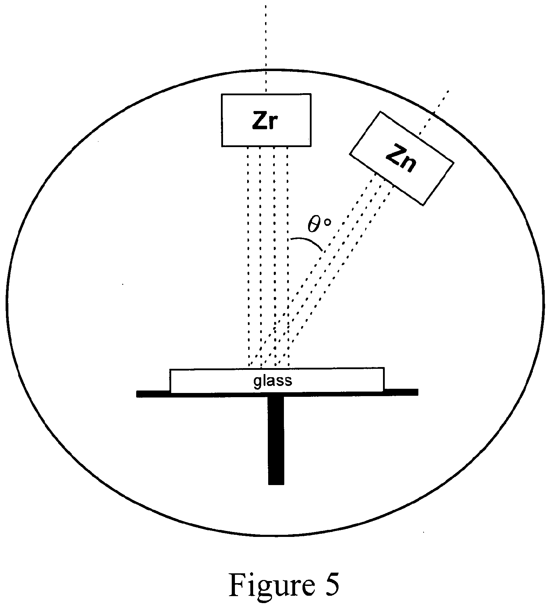

In a first example embodiment, the zinc is sputtered from an angled target. An example of this is shown in Figure 5. More specifically, the Zr target is substantially perpendicular to the substrate, and the Zn target is offset by an angle of theta (θ), as shown in Figure 5. This position assists informing a layer 3 with zinc oxide "hidden" in a zirconium oxide matrix, and helps maintain the stability of the crystalline formation in the coating after optional heat-treatment. As used herein, "Zr target" includes a target comprising zirconium and/or zirconium oxide, and "Zn target" includes a target comprising zinc and/or zinc oxide. Moreover, there may be small amounts of other elements included in each target.

The angle theta (θ), between the Zr and Zn targets, as shown in Figure 5, is from about 5 to about 60 degrees, more preferably from about 10 to about 50 degrees, and most preferably from about 30 to about 45 degrees. This can be accomplished by leaving the Zr target substantially perpendicular to the plane of the substrate 1, and tilting the Zn target such that the angle between the two targets is theta (θ), as shown in Figure 5. In certain example embodiments the aforesaid ranges result in a good overlap of Zn and Zr particles in layer 3, which in turn forms a well-mixed zirconium oxide matrix in which zinc oxide is "hidden."

In a second example embodiment, the coating is deposited via power controlled co-sputtering. In this embodiment, the Zr and Zn targets may or may not be substantially parallel, and are sputtered using different powers to control the composition and crystallinity of the layer 3 in a desirable manner.

According to claim 1, in depositing layer 3 the power used with the Zn target is from about 1.6 to 3.6 kW, most preferably from about 2.1 to 3.1 kW, with an example value of 1.6 kW. For the Zr target, the power used in depositing layer 3 is from about 1.5 to 3.5 kW, more preferably from about 2.0 to 3.0 kW, with an example value of 1.5 kW. The power of each target may be substantially constant throughout deposition, or may be varied.

In a reference example embodiment, one target used in depositing layer 3 may comprise zirconium and zinc (and possibly oxides of each) in a certain ratio which operates to help control the composition and crystallinity of the layer 3. For example, the target may contain a patched pattern of zirconium and zinc to ensure that each respective element is deposited in the desired amount, and is in substantially crystalline form (or in a formation that is conducive to becoming crystalline upon heat treatment). The target may also comprise any pattern that would create the appropriate ratio and structure when sputtered. The first, second, and third embodiments described herein may or may not be used in combination with each other.

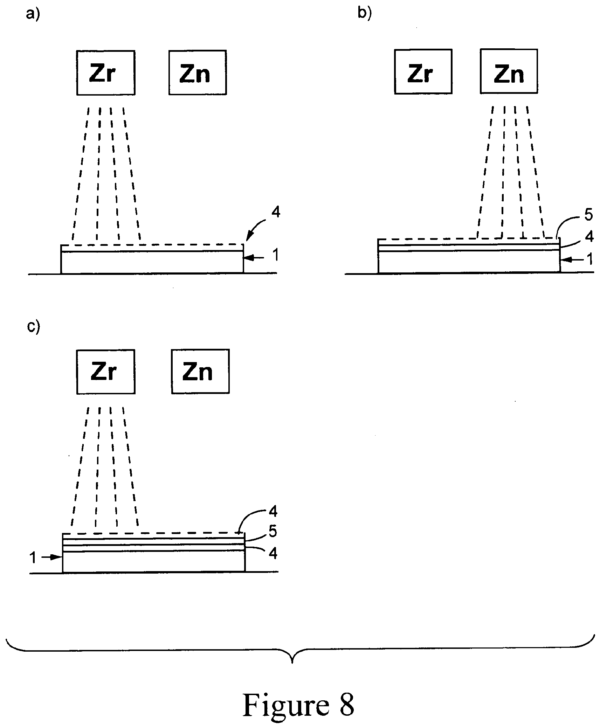

Another reference embodiment includes sequential sputtering from separate Zn and Zr targets. In this embodiment, thin, alternating layers of zirconium (or zirconium oxide) and zinc (or zinc oxide) would be formed. For example, in Figure 8a a zirconium oxide based layer 4 is sputtered first on the glass substrate 1. Then, in Figure 8b a zinc oxide based layer 5 is sputtered second. Fig. 8c illustrates an example of then sputtering zirconium a second time to form another zirconium oxide layer over the zinc oxide layer 5. Figures 8a, 8b, and 8c represent discrete layers formed by sequential sputtering prior to heat treatment as an example only; and the order in which these layers are sputtered can be altered. In this embodiment, the discrete layers are formed prior to thermal tempering. It is possible that the zinc can be sputtered first in other example embodiments. During thermal tempering, there can be migration or diffusion between the layers of the Fig. 8 embodiment. With the approach described herein, it is possible that interdiffusion between discrete layers 4, 5 during tempering/heat treatment can result in a coating with the desired anti-microbial properties. Following HT for example, a layer comprising zinc zirconium oxide may result, as described above with respect to any of the other embodiments herein.

Again, in any of the above embodiments, metal or ceramic targets can be used. The targets may be planar targets or rotating cylindrical magnetron sputtering targets, or a combination thereof.

The ratio of zirconium to zinc (not including any oxygen that may be present) in the layer comprising zinc zirconium oxide in any example embodiment can be from about 2.5 to 200 in example embodiments, more preferably about 3.33 to 100, and most preferablyfrom about 6.67 to 50. Deposition may take place in the presence of oxygen, argon, and/or other gases. The oxygen flow rate used in sputter-depositing the zinc oxide and/or zirconium oxide may be between about 8 and about 28 sccm in certain example embodiments; more preferably from about 13 to 23 sccm; and most preferably from about 16 to 21 sccm. If argon is present, the argon flow rate used in sputter-depositing the zinc oxide and/or zirconium oxide may be from about 10 to 200 sccm, more preferably from about 25 to 175 sccm, and most preferably from about 50 to 150 sccm. It is noted that although zirconium oxide and zinc oxide may be expressed as ZrO₂ and ZnO respectively, and the layer formed may be expressed as being of or comprising ZnₓZr_{y}O_{z}, the layer and/or coating is not necessarily fully oxidized and stoichiometric. Partial oxidation and full oxidation of this layer and/or coating are possible. More or less oxygen will be present in the layer depending on several factors, including the oxygen flow rate during deposition.

The layer formed may have the formula zinc zirconium oxide. Before and/or after heat treatment, in the layer comprising zinc zirconium oxide the zinc may constitute from about 0.25% to 15% (atomic) of the layer, more preferably from about 0.5% to 10%, and most preferably from about 1% to 8% of the layer. Before and/of after HT, the zirconium may constitute from about 20% to about 50% (atomic) of the layer comprising zinc zirconium oxide, more preferably about 25% to 45%, and most preferably from about 30% to 40% of the layer. Before and/or after HT, the oxygen may constitute from about 40% to 80% (atomic) of the layer comprising zinc zirconium oxide, more preferably from about 50% to 70% of the layer, and most preferably from about 55% to about 65% of the layer. These ranges are advantageous because, for example and without limitation, if the zinc concentration is too low, there will be insufficient zinc at the surface to adequately inhibit fungal and/or bacterial growth, and if the zinc concentration is too high, the chemical stability and environmental durability of the coating will degrade.

The thickness of the layer comprising zinc zirconium oxide described in the above embodiments can be from about 10 to 1000 Å in certain example embodiments, more preferably from about 200 to 800 Å, most preferably from about 400 to 600 Å, with an example thickness being about 550 Å in an example embodiment. 1 Å = 0.1 nm.

The layer described in the above embodiments is not limited to zinc, zirconium, and oxygen. Other materials may be present in this layer, and other layers may be provided over or under the zinc zirconium oxide-based layer. However, in certain example embodiments, the layer may comprise, consist essentially of, or consist of, ZnₓZr_{y}O_{z}.

This coating and glass making up the coated article may or may not be heat treated in certain example embodiments. The terms "heat treatment" and "heat treating" as used herein mean heating the article to a temperature sufficient to enabling thermal tempering, bending, and/or heat strengthening of the glass. This includes, for example, heating an article to a temperature of at least about 580 or 600 degrees C for a sufficient period to enable tempering and/or heat strengthening

In certain example embodiments, co-sputtered zirconium and zinc oxides result in a zinc zirconium oxide-based layer that exhibits excellent scratch resistance, combined with anti-bacterial and/or anti-microbial properties. In a simple scratch test where a 3.2 mm (=1/8 inch) diameter borosilicate sphere is dragged across the surface of the coated article, the load which causes a visible scratch on the coated surface can be as high as 10, 15 or 20 pounds. In comparison, uncoated glass fails this test at less than 0.5 pounds. The layer comprising zinc zirconium oxide can pass a 10 lb., 15 lb., and/or 20 lb. scratch test with borosilicate sphere without being scratched in certain example embodiments. 1 lbs = 0.45 kg.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

## Claims

1. A method for making a coated article, the method comprising:
providing a first sputtering target comprising Zr;
providing a second sputtering target comprising Zn; and
co-sputtering from at least the first and second sputtering targets onto a glass substrate (1) to form a layer (3) comprising ZnₓZr_{y}O_{z}, which has anti -bacterial and/or anti-microbial properties,
wherein a different sputtering power is applied for each of the first and second targets in order to control the composition of the layer (3), wherein the power for the Zn target is from 1.6 to 3.6 kW, and the power for the Zr target is from 1.5 to 3.5 kW.

2. A method for making a coated article, the method comprising:
providing a first sputtering target comprising Zr;
providing a second sputtering target comprising Zn; and
co-sputtering from at least the first and second sputtering targets to form a layer (3) comprising ZnₓZr_{y}O_{z} on a glass substrate (1), which has anti -bacterial and/or anti-microbial properties,
wherein the first and second sputtering targets are offset from each other by an angle theta (θ) wherein the angle theta (θ) is greater than 5 degrees and less than 60 degrees, preferably is from 30 to 45 degrees, and wherein the first sputtering target is substantially perpendicular to the substrate.

3. The method of claim 1 or 2, further comprising thermally tempering the coated article.

4. The method of claim 1 or 2, wherein the layer comprises from 0.25% to 15% (atomic) Zn, from 20% to 50% (atomic) Zr, and from 40% to 80% (atomic) O.

## Patentansprüche

1. Ein Verfahren zum Herstellen eines beschichteten Artikels, wobei das Verfahren umfasst:
Bereitstellen eines ersten Sputternziels umfassend Zr;
Bereitstellen eines zweiten Sputternziels umfassend Zn; und
Co-Sputtern von zumindest dem ersten und zweiten Sputternziels auf ein Glassubstrat (1), um eine Schicht (3) umfassend ZnₓZr_{y}O_{z} zu bilden, welche antibakterielle und/oder antimikrobielle Eigenschaften hat,
wobei eine unterschiedliche Sputternenergie für jeweils das erste und zweite Ziel angewendet wird, um die Komposition der Schicht (3) zu steuern, wobei die Energie des Zn-Ziels 1,6 bis 3,6 kW beträgt und die Energie für das Zr-Ziel 1,5 bis 3,5 kW beträgt.

2. Ein Verfahren zum Herstellen eines beschichteten Artikels, wobei das Verfahren umfasst:
Bereitstellen eines ersten Sputternziels umfassend Zr;
Bereitstellen eines zweiten Sputternziels umfassend Zn; und
Co-Sputtern von zumindest dem ersten und zweiten Sputternziels auf ein Glassubstrat (1), um eine Schicht (3) umfassend ZnₓZr_{y}O_{z} zu bilden, welche antibakterielle und/oder antimikrobielle Eigenschaften hat,
wobei das erste und zweite Sputternziel voneinander durch einen Winkel Theta (Θ) versetzt ist, wobei der Winkel Theta (Θ) größer als 5 Grad und weniger als 60 Grad ist, vorzugsweise 30 bis 45 Grad, und wobei das erste Sputternziel im Wesentlichen orthogonal zu dem Substrat ist.

3. Das Verfahren nach Anspruch 1 oder 2, weiter umfassend thermisches Temperieren des beschichteten Artikels.

4. Das Verfahren nach Anspruch 1 oder 2, wobei die Schicht 0,25 % bis 15 % (atomares) Zn umfasst, 20 % bis 50 % (atomares) Zr und 40 % bis 80 % (atomaren) O.

## Revendications

1. Procédé de fabrication d'un article revêtu, le procédé comprenant :
la fourniture d'une première cible de pulvérisation cathodique, comprenant du Zr;
la fourniture d'une seconde cible de pulvérisation cathodique, comprenant du Zn ; et
la co-pulvérisation cathodique, à partir d'au moins la première et la seconde cibles de pulvérisation cathodique, sur un substrat de verre (1) pour former une couche (3) comprenant du ZnₓZr_{y}O_{z}, qui présente des propriétés antibactériennes et/ou antimicrobiennes,
dans lequel une puissance de pulvérisation cathodique différente est appliquée sur chacune de la première et de la seconde cibles dans le but de réguler la composition de la couche (3), la puissance pour la cible Zn étant de 1,6 à 3,6 kW, et la puissance pour la cible Zr étant de 1,5 à 3,5 kW.

2. Procédé de fabrication d'un article revêtu, le procédé comprenant :
la fourniture d'une première cible de pulvérisation cathodique, comprenant du Zr;
la fourniture d'une seconde cible de pulvérisation cathodique, comprenant du Zn ; et
la co-pulvérisation cathodique, à partir d'au moins la première et la seconde cibles de pulvérisation cathodique, pour former une couche (3) comprenant du ZnₓZr_{y}O_{z} sur un substrat de verre (1), qui présente des propriétés antibactériennes et/ou antimicrobiennes,
dans lequel la première et la seconde cibles de pulvérisation cathodique sont décalées l'une par rapport à l'autre d'un angle thêta (θ), l'angle thêta (θ) étant supérieur à 5 degrés et inférieur à 60 degrés, de préférence de 30 à 45 degrés, et la première cible de pulvérisation cathodique étant sensiblement perpendiculaire au substrat.

3. Procédé selon la revendication 1 ou 2, comprenant en outre la trempe thermique de l'article revêtu.

4. Procédé selon la revendication 1 ou 2, dans lequel la couche comprend de 0,25 % à 15 % (en atomes) de Zn, de 20 % à 50 % (en atomes) de Zr, et de 40 % à 80 % (en atomes) d'O.
